# EUROPÄISCHE PATENTSCHRIFT

(11) **EP 2 769 436 B1**
(45) Veröffentlichungstag und Bekanntmachung des Hinweises auf die Patenterteilung: **15.02.2017**
(21) Anmeldenummer: 12758851.5
(22) Anmeldetag: 12.09.2012
(51) Int. Cl.: H02J 7/00, G01R 31/36, G01R 31/28, H01M 10/48, H01M 10/42

(54) **BATTERIE MIT STEUERGERÄT UND ZUSÄTZLICHER SCHNITTSTELLE**
BATTERY HAVING A CONTROL DEVICE AND AN ADDITIONAL INTERFACE
BATTERIE ÉQUIPÉE D'UNE COMMANDE ET D'UNE INTERFACE SUPPLÉMENTAIRE

(30) Priorität: 18.10.2011 DE 102011084689
(43) Veröffentlichungstag der Anmeldung: 27.08.2014
(73) Patentinhaber: Robert Bosch GmbH, 70442 Stuttgart (DE); Samsung SDI Co., Ltd., Yongin-si, Gyeonggi-do 446-577 (KR)
(72) Erfinder: ZIMMERMANN, Ulrich, 74394 Hessigheim (DE)
(74) Vertreter: Bee, Joachim
(86) Internationale Anmeldenummer: PCT/EP2012/067751
(87) Internationale Veröffentlichungsnummer: WO 2013/056899

(56) Entgegenhaltungen:
- US-A- 6 025 698
- US-A1- 2007 080 662
- US-B1- 7 059 769

## Beschreibung

Die vorliegende Erfindung betrifft eine Batterie mit einem Steuergerät und einer zusätzlichen Schnittstelle, ein Kraftfahrzeug mit einer erfindungsgemäßen Batterie, einen Analysestecker für eine erfindungsgemäße Batterie sowie ein Verfahren zur Überwachung einer Batterie.

### Stand der Technik

Es zeichnet sich ab, dass in Zukunft sowohl bei stationären Anwendungen (z. B. bei Windkraftanlagen) als auch in Fahrzeugen wie Hybrid- und Elektrofahrzeugen vermehrt neue Batteriesysteme zum Einsatz kommen werden, an die sehr hohe Anforderungen bezüglich Zuverlässigkeit gestellt werden. Hintergrund für diese hohen Anforderungen ist, dass ein Ausfall der Batterie zu einem Ausfall des Gesamtsystems oder sogar zu einem sicherheitsrelevanten Problem führen kann. So werden beispielsweise bei Windkraftanlagen Batterien eingesetzt, um bei starkem Wind die Anlage durch eine Rotorblattverstellung vor unzulässigen Betriebszuständen zu schützen.

Um diesen Schutz zu gewährleisten, umfassen Batterien üblicherweise ein Steuergerät, das Betriebsdaten der Batterie überwachen und den Betrieb der Batterie zuverlässig steuern kann. Mit dem Steuergerät kann über eine Datenleitung kommuniziert werden, um relevante Zustandsdaten der Batterie abzufragen. Ferner kann über dieses Steuergerät die interne Hochspannung der Batterie auf die äußeren Anschlüsse geschaltet werden, um der Batterie Energie zu entnehmen.

Aus der Offenlegungsschrift DE 10 2009 046 564 A1 ist beispielsweise eine Batterie-Steuergerät-Architektur bekannt, dergemäß ein Steuergerät einen Microcontroller sowie einen Nanocontroller umfasst, die über einen Kommunikationsbus mit Überwachungseinheiten an den einzelnen Batteriezellen verbunden sind und dadurch verschiedene Eigenschaften der Batterie oder einzelner Batteriezellen, beispielsweise Temperatur und Ladezustand, erfassen und überwachen können.

Nachteilig am Stand der Technik ist, dass die Kommunikation ausschließlich über das integrierte Steuergerät möglich ist und bei einem Ausfall des oftmals höchst komplexen Steuergeräts kein Zugriff mehr auf die Batterie besteht, wodurch es unmöglich wird, Betriebsdaten der Batterie auszulesen und/oder die Batterie bei Auftreten eines kritischen Zustands zu entladen. Dies führt häufig dazu, dass beschädigte Batterien unter hohem Aufwand und Kosten entsorgt werden müssen.

### Offenbarung der Erfindung

Erfindungsgemäß wird eine Batterie mit einem Steuergerät (14) zur Verfügung gestellt, wobei die Batterie (10) mindestens eine Batteriezelle und/oder mindestens ein Batteriemodul umfasst,dadurch gekennzeichnet, dass die Batterie (10) ferner mindestens eine Messschaltung (12), sowie einen Kommunikationsbus (20) zur Kommunikation zwischen dem Steuergerät (14) und der mindestens einen Messschaltung (12), sowie eine Schnittstelle (16) umfasst, die dazu ausgebildet ist, eine Messung mindestens einer Temperatur im Inneren der Batterie (10), einer Spannung der Batterie (10) und/oder einer Spannung der mindestens einen Batteriezelle und/oder des mindestens einen Batteriemoduls mittels eines Zugangs zu dem Kommunikationsbus (20) und/oder eine Entladung der Batterie (10) zu ermöglichen, wenn das Steuergerät (14) ausgefallen ist.

In einer bevorzugten Ausführungsform umfasst die Batterie einen Wartungsstecker. Die Schnittstelle kann vorteilhaft im Bereich des Wartungssteckers angeordnet werden, da dieser im Allgemeinen an leicht zugänglichen Orten im Fahrzeug platziert ist, um die Unterbrechung des Stromkreises zwischen den einzelnen Modulen der Batterie zu ermöglichen.

Vorzugsweise ist der Wartungsstecker durch einen Analysestecker ersetzbar. Ein solcher Analysestecker könnte beispielsweise in der Werkstatt gegen den normalen Stecker getauscht werden und dann die oben beschriebenen Zugriffe erlauben.

Der Wartungsstecker und/oder der Analysestecker kann eine Spannungsanzeige umfassen, die dazu ausgebildet ist, anzuzeigen, ob der Ladezustand der Batterie kritisch ist, wenn das Steuergerät ausgefallen ist. Ferner kann der Wartungsstecker und/oder der Analysestecker eine Warnanzeige umfassen, die dazu ausgebildet ist, anzuzeigen, ob die Temperatur der Batterie erhöht ist, wenn das Steuergerät ausgefallen ist. Zu diesem Zweck könnte der Stecker an Temperatursensoren im Inneren der Batterie angeschlossen sein. Der Wartungsstecker und/oder der Analysestecker kann ferner einen Entladewiderstand umfassen. Der Entladewiderstand ließe sich bei Bedarf mit geeigneten Hilfsmitteln aktivieren und erlaubt somit, eine havarierte Batterie vor Ort zu entladen.

Vorteil einer solch einfachen aber schwierig zu zerstörenden Überwachung ist, dass auch bei Beschädigungen der Batterie, die zu einem Ausfall des Batteriesteuergerätes und damit der normalen Kommunikation mit der Batterie führen, immer noch einige Grundinformationen über den Batteriezustand gewonnen werden können.

Erfindungsgemäß wird außerdem ein Kraftfahrzeug zur Verfügung gestellt, insbesondere ein elektrisches Kraftfahrzeug, das eine erfindungsgemäße Batterie umfasst. Die Erfindung stellt ferner einen Analysestecker bereit, der dazu ausgebildet ist, den Wartungsstecker einer erfindungsgemäßen Batterie zu ersetzen. Außerdem wird ein Verfahren zur Überwachung einer Batterie bereitgestellt, in dem über eine Schnittstelle eine Messung von Batterieeigenschaften und/oder eine Entladung der Batterie ermöglicht wird, wenn das Steuergerät ausgefallen ist.

### Zeichnungen

Ein Ausführungsbeispiel der Erfindung wird anhand der Zeichnung und der nachfolgenden Beschreibung näher erläutert. Es zeigt:

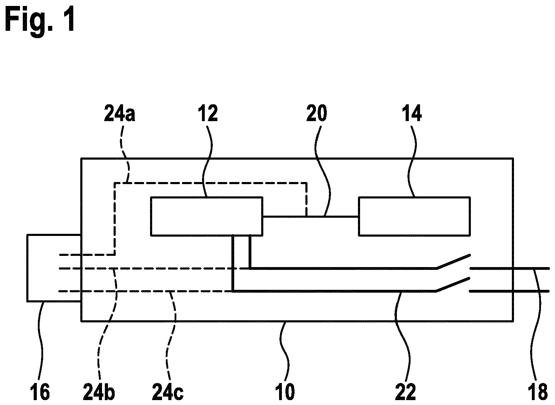

Figur 1 eine erfindungsgemäße Batterie mit einem Wartungsstecker.

### Ausführungsformen der Erfindung

In der Figur 1 ist eine Batterie 10 gezeigt, die eine Zellüberwachungsschaltung (Cell Supervision Circuit) 12, ein Batterie-Management-System 14, einen Wartungsstecker 16 und einen Hochspannungs-Anschluss 18 umfasst. Das Batterie-Management-System 14 kommuniziert im voll funktionsfähigen Zustand der Batterie 10 über einen Kommunikationsbus 20 mit der Zellüberwachungsschaltung 12, die über Leitungen 22 mit dem Hochspannungsanschluss 18 leitend verbunden ist. Von dem Wartungsstecker 16 führen Leitungen 24a, 24b, 24c zu dem Kommunikationsbus 20 sowie zu den Leitungen 22. Somit dient der Wartungsstecker 16 als Schnittstelle, über die ein redundanter Zugang zu elementaren Daten und Funktionen der Batterie 10 besteht. Sollte das integrierte Batterie-Management-System 14 ausfallen, so kann über den Wartungsstecker 16 mittels der Leitung 24a weiterhin auf den Kommunikationsbus 20 zugegriffen werden, über den Daten aus der Zellüberwachungsschaltung 12 ausgelesen werden können. Ferner können bei Ausfall des Batterie-Management-Systems 14 und/oder der Zellüberwachungsschaltung 12 über die Leitungen 24b, 24c weiterhin die Packspannung und/oder Teilspannungen, beispielsweise die Spannungen einzelner Batteriemodule oder einzelner Batteriezellen abgegriffen werden. Bei Eintreten eines kritischen Zustands kann die Batterie 10 außerdem über die Leitungen 24b, 24c auch bei Ausfall des Batterie-Management-Systems 14 und/oder der Zellüberwachungsschaltung 12 noch sicher und ohne aufwändige Zerlegung entladen werden.

## Patentansprüche

1. Batterie (10) mit einem Steuergerät (14), wobei die Batterie (10) mindestens eine Batteriezelle und/oder mindestens ein Batteriemodul umfasst, **dadurch gekennzeichnet, dass** die Batterie (10) ferner mindestens eine Messschaltung (12), sowie einen Kommunikationsbus (20) zur Kommunikation zwischen dem Steuergerät (14) und der mindestens einen Messschaltung (12), sowie eine Schnittstelle (16) umfasst, die dazu ausgebildet ist, eine Messung mindestens einer Temperatur im Inneren der Batterie (10), einer Spannung der Batterie (10) und/oder einer Spannung der mindestens einen Batteriezelle und/oder des mindestens einen Batteriemoduls mittels eines Zugangs zu dem Kommunikationsbus (20) und/oder eine Entladung der Batterie (10) zu ermöglichen, wenn das Steuergerät (14) ausgefallen ist.

2. Batterie (10) nach Anspruch 1, wobei die Schnittstelle (16) der Batterie (10) einen Wartungsstecker (16) umfasst und wobei die Schnittstelle im Bereich des Wartungssteckers (16) angeordnet ist, wobei der Wartungsstecker (16) vorzugsweise durch einen Analysestecker ersetzbar ist.

3. Batterie (10) nach Anspruch 2, wobei der Wartungsstecker (16) und/oder der Analysestecker eine Anzeige umfasst, die dazu ausgebildet ist, anzuzeigen, ob ein kritischer Zustand der Batterie (10) vorliegt, insbesondere, ob der Ladezustand der Batterie (10) kritisch ist und/oder ob die Temperatur der Batterie (10) erhöht ist, wenn das Steuergerät (14) ausgefallen ist.

4. Batterie (10) nach einem der Ansprüche 2 oder 3, wobei der Wartungsstecker (16) und/oder der Analysestecker einen Entladewiderstand umfasst.

5. Kraftfahrzeug, insbesondere elektrisches Kraftfahrzeug, umfassend eine Batterie (10) nach einem der vorangehenden Ansprüche 1 bis 4.

6. Analysestecker, **dadurch gekennzeichnet, dass** der Analysestecker dazu ausgebildet ist, den Wartungsstecker (16) einer Batterie (10) nach einem der Ansprüche 2 bis 4 zu ersetzen.

7. Verfahren zur Überwachung einer Batterie (10), **dadurch gekennzeichnet, dass** über eine Schnittstelle (16) mittels einer Messschaltung (12) mindestens eine Temperatur im Inneren der Batterie (10), einer Spannung der Batterie (10) und/oder einer Spannung der mindestens einen Batteriezelle und/oder des mindestens einen Batteriemoduls und/oder eine Entladung der Batterie (10) durchgeführt wird, wenn das Steuergerät (14) ausgefallen ist.

## Claims

1. Battery (10) having a controller (14), wherein the battery (10) comprises at least one battery cell and/or at least one battery module, **characterized in that** the battery (10) further comprises at least one measuring circuit (12), and also a communication bus (20) for communication between the controller (14) and the at least one measuring circuit (12), and also an interface (16) that is designed to allow at least one temperature inside the battery (10), a voltage of the battery (10) and/or a voltage of the at least one battery cell and/or of the at least one battery module to be measured by means of access to the communication bus (20), and/or the battery (10) to be discharged when the controller (14) has failed.

2. Battery (10) according to Claim 1, wherein the interface (16) of the battery (10) comprises a service connector (16) and wherein the interface is arranged in the region of the service connector (16), the service connector (16) preferably being replaceable by an analysis connector.

3. Battery (10) according to Claim 2, wherein the service connector (16) and/or the analysis connector comprise(s) a display that is designed to display whether there is a critical state of the battery (10), particularly whether the state of charge of the battery (10) is critical and/or whether the temperature of the battery (10) is raised, when the controller (14) has failed.

4. Battery (10) according to either of Claims 2 and 3, wherein the service connector (16) and/or the analysis connector comprise(s) a discharge resistor.

5. Motor vehicle, in particular electric motor vehicle, comprising a battery (10) according to one of the preceding Claims 1 to 4.

6. Analysis connector, **characterized in that** the analysis connector is designed to replace the service connector (16) of a battery (10) according to one of Claims 2 to 4.

7. Method for monitoring a battery (10), **characterized in that** an interface (16) is used to perform, by means of a measuring circuit (12), at least one temperature inside the battery (10), of a voltage of the battery (10) and/or of a voltage of the at least one battery cell and/or of the at least one battery module, and/or discharge of the battery (10), when the controller (14) has failed.

## Revendications

1. Batterie (10) avec un appareil de commande (14), la batterie (10) comprenant au moins une cellule de batterie et/ou au moins un module de batterie, **caractérisée en ce que** la batterie (10) comprend en outre au moins un circuit de mesure (12), ainsi qu'un bus de communication (20) destiné à la communication entre l'appareil de commande (14) et l'au moins un circuit de mesure (12), ainsi qu'une interface (16), laquelle est conçue pour permettre une mesure d'au moins une température à l'intérieur de la batterie (10), une tension de la batterie (10) et/ou une tension de l'au moins une cellule de batterie et/ou de l'au moins un module de batterie, au moyen d'un accès au bus de communication (20) et/ou pour permettre une décharge de la batterie (10) quand l'appareil de commande (14) est défaillant.

2. Batterie (10) selon la revendication 1, l'interface (16) de la batterie (10) comprenant un connecteur de maintenance (16) et l'interface étant disposée dans la zone du connecteur de maintenance (16), où le connecteur de maintenance (16) peut être remplacé, de préférence, par un connecteur de diagnostic.

3. Batterie (10) selon la revendication 2, le connecteur de maintenance (16) et/ou le connecteur de diagnostic comprenant un affichage, lequel est conçu pour indiquer si l'état actuel de la batterie (10) est critique, en particulier si l'état de charge de la batterie (10) est critique et/ou si la température de la batterie (10) s'est accrue quand l'appareil de commande (14) est devenu défaillant.

4. Batterie (10) selon l'une des revendications 2 ou 3, le connecteur de maintenance (16) et/ou le connecteur de diagnostic comprenant une résistance de décharge.

5. Véhicule à moteur, en particulier véhicule à moteur électrique, comprenant une batterie (10) selon l'une des revendications précédentes 1 à 4.

6. Connecteur de diagnostic, **caractérisé en ce que** le connecteur de diagnostic est conçu en vue de se substituer au connecteur de maintenance (16) d'une batterie (10) selon l'une des revendications 2 à 4.

7. Procédé destiné à la surveillance d'une batterie (10), **caractérisé en ce qu'**au moins une température à l'intérieur de la batterie (10), d'une tension de la batterie (10) et/ou d'une tension de l'au moins une cellule de batterie et/ou de l'au moins un module de batterie et/ou une décharge de la batterie (10) sont réalisées par l'intermédiaire d'une interface (16), au moyen d'un circuit de mesure (12), quand l'appareil de commande (14) est défaillant.
